Europäisches Patentamt

(19) European Patent Office

Office européen des brevets

(11) **EP 0 704 706 B1**

(12) **EUROPEAN PATENT SPECIFICATION**

(45) Date of publication and mention
of the grant of the patent:
**30.06.1999 Bulletin 1999/26**

(51) Int Cl.6: **G01P 21/00**, G01R 31/28

(21) Application number: **95115291.7**

(22) Date of filing: **28.09.1995**

(54) **A diagnostic system for a capacitive sensor**

Diagnosesystem für einen kapazitiven Sensor

Système diagnostique pour un capteur capacitif

(84) Designated Contracting States:
**DE ES FR GB SE**

(30) Priority: **30.09.1994 IT TO940764**

(43) Date of publication of application:
**03.04.1996 Bulletin 1996/14**

(73) Proprietor: **MAGNETI MARELLI S.p.A.**
**20145 Milano (IT)**

(72) Inventor: **Salerno, Franco**
**I-10091 Alpignano (Torino) (IT)**

(74) Representative: **Quinterno, Giuseppe et al**
**c/o JACOBACCI & PERANI S.p.A.**
**Corso Regio Parco, 27**
**10152 Torino (IT)**

(56) References cited:
EP-A- 0 615 119        WO-A-88/01242
WO-A-91/09315        DE-A- 3 235 660
GB-A- 2 253 487

- **MEASUREMENT SCIENCE AND TECHNOLOGY
vol. 5, no. 1, BRISTOL GB, pages 20 - 26 TAPSON
ET AL. 'IMPROVED CAPACITANCE
MEASUREMENT BY MEANS OF RESONANCE
LOCKING'**

## Description

The present invention relates in general to a diagnostic system for a capacitive sensor, of the kind defined in the preamble of claim 1.

Such a system is disclosed in J. Tapson and J. R. Greene: "Improved capacitance measurement by means of resonance locking", Measurement Science and Technology, Vol.5, no.1, 1994, Bristol, GB, pages 20-26. This article describes an LC method of capacitance measurement consisting of a synthesis of LC resonance and LC oscillator methods. An LC tank circuit is driven by a voltage-controlled oscillator (VCO) and is included in an analogue phase-locked loop which is designed to lock with no difference between current flow and driving voltage in the tank circuit. The system tracks the resonance peak as the capacitance changes thus allowing automatic measurement of capacitance by monitoring the VCO input voltage or output frequency.

In internal combustion engines currently in production, in particular in engines intended for motor vehicle use, the use of capacitive detonation sensors is becoming widespread.

The necessity to be able to perform diagnostics on such sensors is therefore grown. It is known in the art to effect diagnosis by direct measurement of the impedance relating to the sensor. This method, however, presents the disadvantage of increasing the cost and the complexity of the sensor itself.

The object of the present invention is that of providing a diagnostic system which permits all the above-indicated problems to be resolved in a satisfactory manner.

According to the present invention, this object is achieved by a diagnostic system having the features defined in Claim 1.

Further advantages and characteristics of the present invention will become evident from the following detailed description, given with the aid of the attached drawings provided purely by way of no-limitative example, in which:

- Figure 1 is a block schematic representation of a diagnostic system according to the present invention;
- Figures 2 and 3 are schematic representations of the system of Figure 1 in two different operating conditions;
- Figures 4 and 5 are diagrams for illustrating the operation of the system of Figure 1;
- Figures 6 and 7 are schematic circuit representations of portions of the system of Figure 1.

The system according to the present invention has been developed to diagnose the state of the input connection of a device for detecting detonation (also called knock) which utilises a piezoelectric accelerometric sensor of capacitive type.

In particular, the system solves the following problem:
given a system for the detection of detonation, find a method which succeeds in diagnosing the following conditions at the input of the device:

- sensor connected;
- sensor disconnected (that is to say, connection of only the sensor cabling);
- sensor short circuited to the supply voltage;
- sensor short circuited to ground.

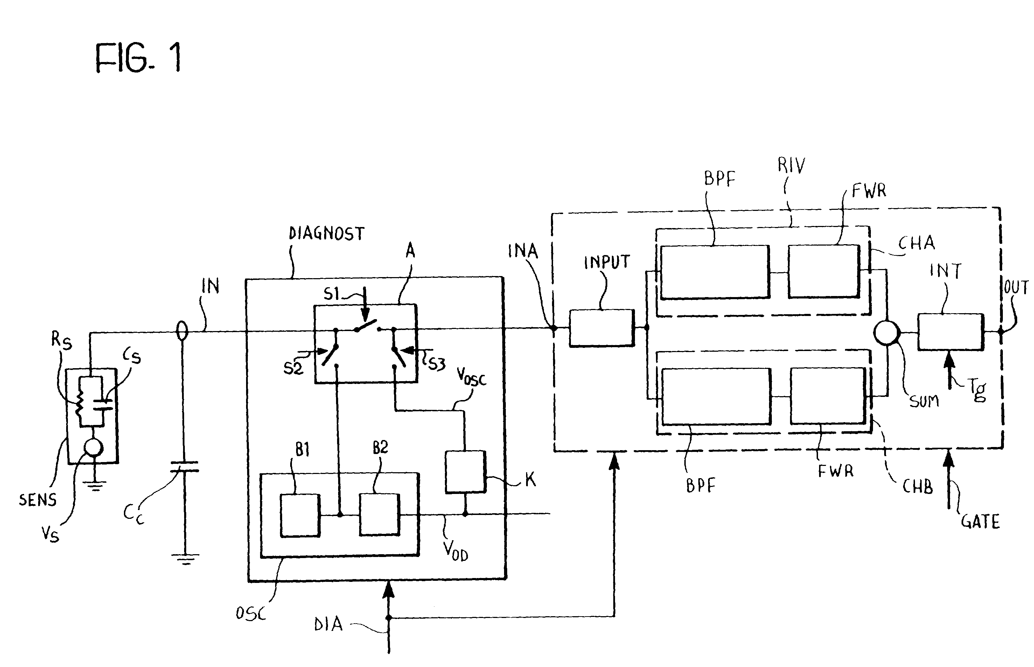

The system utilises an oscillator which, during diagnosis, is connected between the sensor and a detection device or detector (see in this connection the block diagram of Figure 1). The frequency of the oscillator depends on the capacitance present at the input terminal of the system itself. If the sensor is connected the oscillator frequency falls within the detector band and therefore at the output of the detector there will be a signal greater than a discrimination threshold; if the sensor is detached the oscillator frequency will be so high as to fall outside the detector band and therefore will have at its output a signal less than the discrimination threshold, in the limit a zero threshold.

If the input terminal is short circuited to ground or to the supply voltage the oscillator (of digital type) remains clamped at low or high logic level respectively, whilst the output of the detector will in both cases be less than the discrimination threshold, in the limit zero.

The system is general and can be applied to detonation detection devices having one or several tuning channels. The system will now be described in more detail in the case of a two-channel device.

The diagnostic system according to the invention is based on a block diagram of the type shown in Figure 1. The diagnostic system DIAGNOST is interposed between a sensor SENS and a detector circuit RIV during the diagnostic phase, which is activated by means of a digital "high" signal DIA.

The detector circuit RIV comprises an interface amplifier INPUT connected to the input INA of the detector circuit RIV. The output of the interface amplifier INPUT is connected to two tuning channels CHA and CHB. The outputs of the two tuning channels CHA and CHB join together at a summing node SUM which in turn is connected to an integrator INT with an integration time Tg, the output of which is connected to the output OUT of the detector circuit RIV. Each of the two tuning channels CHA, CHB is in turn composed of a band pass filter BPF and a double half wave rectifier FWR.

The diagnostic system DIAGNOST is, on the other hand, constituted by the following fundamental blocks:

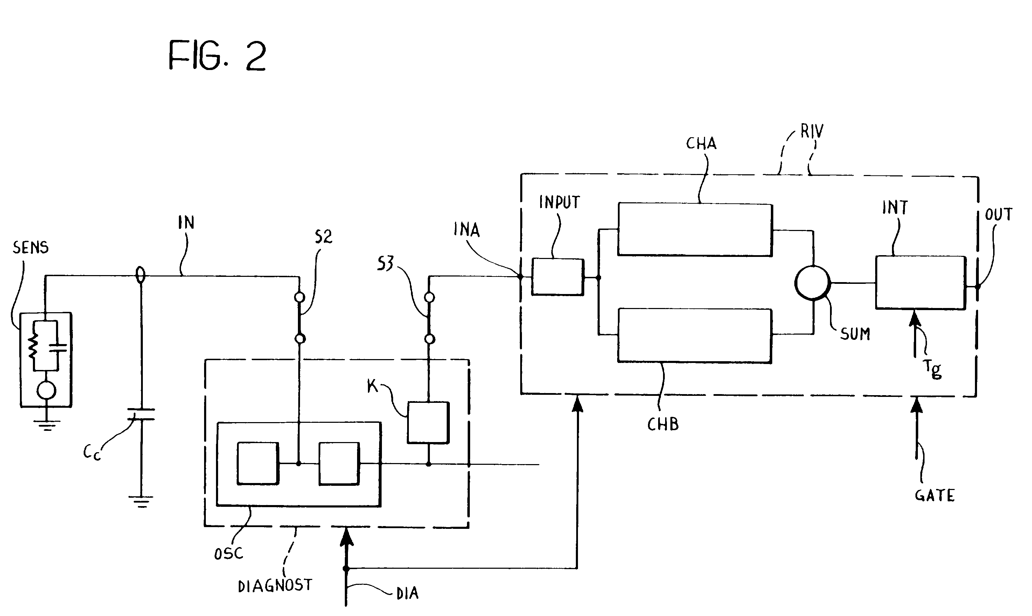

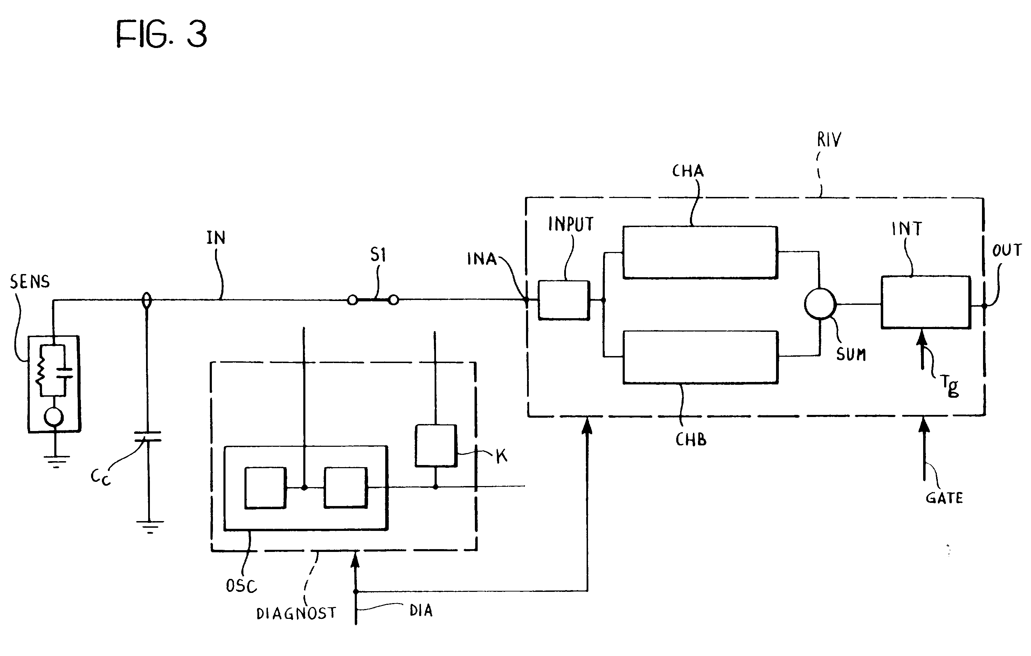

- switching block A: this is constituted by three switches S1, S2, S3. When diagnosis is enabled by the high level of the signal DIA, the switches S2 and S3 are closed while S1 is open; in these conditions an oscillator OSC is connected between the sensor SENS and the detector circuit RIV. This situation is illustrated in Figure 2. During normal operation, with the signal DIA at low level, switches S2 and S3 are open whilst S1 is closed, consequently, the diagnostic system DIAGNOST is disconnected and the sensor SENS is connected directly to the input INA of the detector circuit RIV. This situation is illustrated in Figure 3.
- Oscillator OSC, already mentioned. This emits a periodic signal the frequency of which depends on the capacitance connected to the output of a sub block B1 (input of the oscillator OSC). Sub block B2 represents the output stage of the oscillator OSC which produces a symmetrical square wave signal of amplitude $V_{od}$. The output, via a level shifter K, is connected to the input of the detector circuit RIV.
- Oscillator output level shifter K, already mentioned. This circuit is not essential for the system DIAGNOST, but is introduced for completeness, and serves to excite the input stage of the detector circuit RIV with a level compatible with the permitted dynamics of the system. Alternatively, the levels of the signals in the detector RIV can be regulated by the signal DIA and, consequently, the factor k can be incorporated in an input stage INPUT of the detector.

The charge present at an input IN of the system DIAGNOST is supposed to be formed by a capacitance $C_c$, which represents the connection of the cabling and possible parasitic capacitances on the input node IN, and the sensor SENS. The sensor SENS is schematically represented by the parallel connection of a capacitance $C_s$ and a resistance $R_s$, and by a voltage generator $V_s$ which converts the acceleration into voltage. For the purposes of the following theoretical consideration, to illustrate the operation of the diagnostic system DIAGNOST the following conditions are presupposed:

- the loss resistance $R_s$ is very high, greater than 1MΩ, for which hereinafter we will put $1/R_s=0$;
- diagnosis of the sensor SENS is enabled when the transducer voltage $V_s$ is small with respect to the oscillator signal OSC, for which hereinafter we will put $V_s = 0$ ;
- the capacitance of the sensor $C_s$ is greater than the parasitic $C_c$, that is to say:

$$C_s > C_c. \tag{1}$$

The system DIAGNOST is based on the fact that, in the diagnostic configuration, the detector RIV acts on the oscillator signal OSC, the frequency of which depends on the equivalent capacitance present at the input IN, thereby determining an output signal from which it is possible to diagnose the connected, detached or short circuited condition of the sensor SENS as will be explained herein below.

The periodic signal which supplies the input interface INPUT of the detector RIV, see Figure 2, is a square wave with a predetermined duty cycle (in general 50%), with an amplitude such as to exploit the maximum available dynamic range of the input interface INPUT and the amplifiers. The level shifter K provides an output voltage adaptation stage of the oscillator OSC according to the relation:

$$V_{osc} = kV_{od} \tag{2}$$

where $V_{osc}$ is the value of the peak-to-peak voltage of the square wave which supplies the input stage INPUT of the detector RIV, $V_{od}$ is the peak-to-peak voltage of the square wave at the output of the oscillator OSC (in general at logic levels), and k is the adaptation constant (attenuation or amplification) of the shifter (K).

The frequency $F_0$ of the oscillator OSC is a function of a capacitance $C_i$ present at the input IN according to the relation:

$$F_o = \frac{K_o}{C_i R_{DIA}} \tag{3}$$

where $R_{DIA}$ is a calibration resistance and $K_o$ is a constant which depends on the type of implementation of the oscillator OSC as will be described hereinafter.

In dependence on the input load conditions it is possible to distinguish the following cases relating to the frequency $F_o$ of the oscillator OSC, and to the output voltage $V_{out}$ of the system:

a) <u>Sensor connected.</u> In this case $C_i = C_s + C_c$, so that the frequency of the oscillator OSC assumes the value $F_s$ given by:

$$F_o (C_s + C_c) = F_s = \frac{K_o}{(C_s + C_c) R_{DIA}} \qquad (4)$$

The constants $K_o$ and $R_{DIA}$ can be chosen in such a way that upon variation of the capacitance of the sensor SENS, within an established interval $C_{smin}$ and $C_{smax}$, the frequency $F_s$ remains within the useful band of the detector RIV; in this case the output voltage of the detector RIV, that is to say $V_{out}(F_s)$, obtained after an integration phase of duration $T_g >> 1/F_s$ assumes a value greater than or equal to the discrimination threshold $V_{ts}$, thus defined:

$$V_{out}(F_s) \geq V_{ts} = \min \{V_{out}(F_s)\} \qquad (5)$$

where $\min\{V_{out}(F_s)\}$ is the minimum value of the output at the frequency defined by the preceding relation (4).

b) <u>sensor detached.</u> In this case $C_i = C_c$ so that the frequency of the oscillator OSC assumes a value $F_{cb}$ given by:

$$F_o (C_c) = F_{cb} \frac{K_o}{C_c R_{DIA}} \qquad (6)$$

In this case the constants $K_o$ and $R_{DIA}$ are dimensioned in such a way that the frequency of the oscillator OSC falls outside the band width of the detector RIV so that the output voltage is less than or equal to a discrimination threshold $V_{tc}$:

$$V_{out}(F_{cb}) \leq V_{tc} = \max\{V_{out}(F_{cb})\} \qquad (7)$$

where $\max\{V_{out}(F_{cb})\}$ is the maximum value of the output at the frequency defined by the preceding relation (6).

From relations (4) and (6) it can be intuitively deducted that the discrimination factor depends on the ratio of the frequency with and without sensor SENS, $F_s$ and $F_{cb}$:

$$\frac{F_{cb}}{F_s} = 1 + \frac{C_s}{C_c} > 2 \qquad (8)$$

to which correspond output voltages of the detector RIV
$V_{out}(F_s)$ and $V_{out}(F_{cb})$ according to the ratio

$$\frac{V_{out}(F_s)}{V_{out}(F_{cb})} \geq \frac{V_{ts}}{V_{tc}} \qquad (9)$$

Thus the system DIAGNOST makes it possible to discriminate between the attached and detached condition of sensor SENS by comparing the voltage on the output OUT of the detector RIV with respect to the discrimination voltages $V_{ts}$ and $V_{tc}$ in dependence on the voltage of the oscillator OSC and the characteristics of the band pass filters BPF of the detector RIV. On the basis of the relation (8) it will be seen below that the relation (9) is always greater by at least 6dB since the sensitivity of the filters BPF in the useful signal band is exploited in an optimal manner as is the so-called roll-off of the filters BPF outside the useful band.

c) <u>Short circuit to ground.</u> In this case, independently of the input capacitance, the output of the oscillator OSC is clamped at a fixed value, for example at zero or a low logic level, whilst the output OUT of the detector RIV is nil since the band pass nature of the filters BPF does not allow DC input voltages to pass; therefore one has:

$$V_{outCCo} \leq V_{tc} \qquad (10)$$

$V_{od} = \text{constant} = V_{LOW}$

d) Short circuit to supply. As in condition (10), in this case too, the output of the detector RIV is less than the threshold $V_{tc}$ since the output of the oscillator OSC is clamped at a fixed value, for example at the high logic level; therefore one has:

$$V_{outCCa} \leq V_{tc} \qquad (11)$$

$V_{od} = \text{constant} = V_{HIGH}$

Calculation of the threshold voltage

The threshold voltages of relations (5) and (7) will now be explained as a function of the parameters of the oscillator OSC and the system DIAGNOST.

The detector RIV is assumed tuned to the channels CHA and CHB at respective central frequencies $F_A$ and $F_B$, gains $G_A$ and $G_B$ and quality factors $Q_A$ and $Q_B$; in general the modulus of the transfer function (hereinafter called FDT for brevity) of the band pass filters BPF will be considered of the type:

## Channel CHA:

$$M_A(f) = G_A \left[ 1 + \left( \frac{F_A^2 - f^2}{F_A f} Q_A \right)^2 \right]^{-1/2} \qquad (12)$$

## Channel CHB:

$$M_B(f) = G_B \left[ 1 + \left( \frac{F_B^2 - f^2}{F_B f} Q_B \right)^2 \right]^{-1/2} \qquad (13)$$

To simplify the following treatment, and given the band pass nature of the filters BPF of the detector RIV the approximation will be made that the output of the filters BPF produces only the first harmonic of the square wave signal present at the input (output of the oscillator OSC); since the upper harmonics are generally above the maximum frequency which can be handled. The amplitude of the first harmonic of the oscillator OSC will therefore be considered of the type:

$$V_{osc1} = V_{osc} K_{a1} \qquad (14)$$

where $K_{a1}$ is the first coefficient of the Fourier series development of the square wave, equal to $2/\pi$ in the case of a symmetrical square wave with ideal edges.

In general, therefore, the voltage at the input of the integrator of the detector RIV is given by:

$$V_I(F_o,t) = V_{osc} K_{a1} [M_A(F_o) + M_B(F_o)] \sin(2\pi F_o t) | \qquad (15)$$

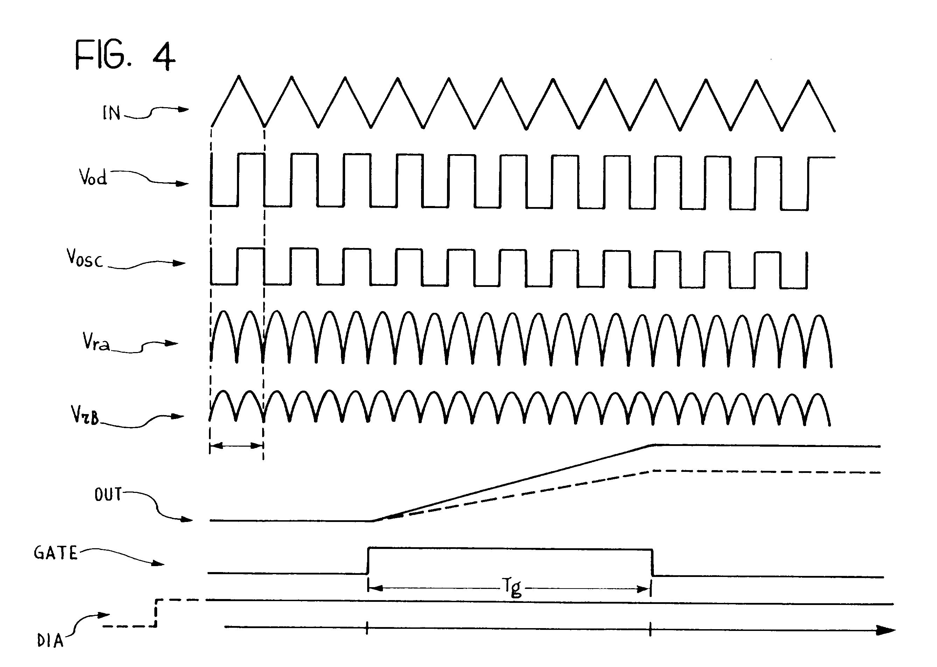

where the approximation has been made that the signals at the output of the double half wave rectifier FWR have a zero phase displacement; a typical plot of the signals of the system is shown for example in Figure 4.

The output of the detector RIV is obtained by integrating the relation (15) for a time $T_g$, determined by the high level of a signal GATE, as shown in Figure 4; for $T_g >> 1/F_o$ , the output voltage is given by:

$$V_{out}(F_o) = 1/\tau \int_{t_1}^{t_1+T_g} V_I(F_o,t)dt = V_{av}(F_o)\ T_g/\tau \qquad (16)$$

where $\tau$ is the time constant of the integrator INT and $V_{av}(F_o)$ is the mean voltage at the input of the integrator INT, which from relation (15) is equal to:

$$V_{av}(F_o) = (2/\pi) \cdot V_{osc}K_{a1}M_{A,B}(F_o) \qquad (17)$$

where the factor $2/\pi$ takes account of the mean of the rectified sinusoid and $M_{A,B}(F_o)$ is the sum of the moduli of the FDT of the channels CHA and CHB at the frequency of the oscillator OSC.

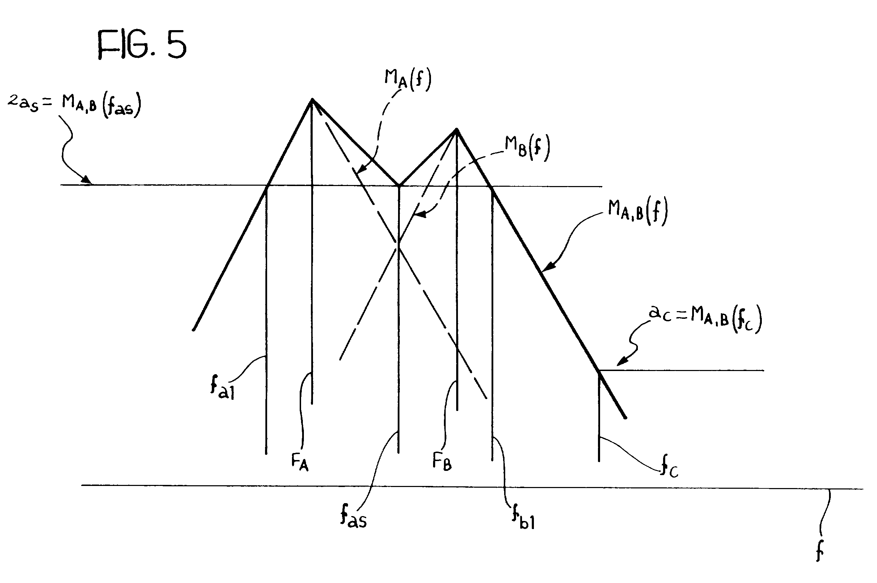

So that the method is efficient it is necessary that the central frequencies of the band pass filters BPF are sufficiently far away from one another as to ensure that the oscillation frequency, in nominal charge conditions, falls in the interval lying between $f_{a1}$ and $f_{b1}$ (supposing $F_B > F_A$). For example, it could be supposed that $F_A$ and $F_B$ are set as in Figure 5.

In this Figure there are schematically shown the FDT modulus of the channels CHA and CHB (broken outline) and the FDT modulus seen at the input of the integrator INT (sum of the moduli of the two FDTs).

Because of the considerations that have been made, when the sensor SENS is connected the oscillation frequency falls in an interval lying between $f_{a1}$ and $f_{b1}$, such that the input signal of the integrator INT is attenuated, at most, by a factor $2a_s$. On the other hand if the sensor SENS is disconnected, the oscillation frequency is so high, greater than $f_c$, that the signal is attenuated at least by a factor $a_c < 2a_s$. The different attenuation in the two cases establishes the discrimination margin between the sensor SENS connected and detached as will explained hereinbelow.

When the sensor SENS is connected the oscillation frequency falls in the interval:

$$f_{a1} \le F_s \le f_{b1} \qquad (18)$$

and, referring to Figure 5, and on the basis of relation (17), the mean voltage at the input of the integrator INT, with the sensor SENS connected, is greater than the threshold $V_{lts}$:

$$V_{av}(F_o) \ge V_{lts} = 2/\pi\ V_{osc}K_{a1}2a_s \qquad (19)$$

where $a_s$ is the maximum attenuation of the sum of the moduli $M_{A,B}(f)$ in the interval $f_{a1}$ and $f_{b1}$, which gives the frequency $f_{as}$ such that the two moduli are equal:

$$a_s = G_A \left[ 1 + \left( \frac{F_A^2 - f_{as}^2}{F_A f_{as}} Q_A \right)^2 \right]^{-1/2} =$$

$$= G_B \left[ 1 + \left( \frac{F_B^2 - f_{as}^2}{F_B f_{as}} Q_B \right)^2 \right]^{-1/2} \qquad (20)$$

In the particular case of $G_A = G_B = G$ and $Q_A = Q_B = Q$, the frequency of $f_{as}$ becomes the geometric mean of the central frequencies $F_A$ and $F_B$, that is to say:

$$f_{as} = F_A F_B \qquad (21)$$

With the sensor SENS detached, the frequency of the oscillator OSC is greater than the frequency $f_c$ in such a way that:

$$F_{cb} \geq f_c > f_{b1} \qquad (22)$$

so that, at the frequency $F_{cb}$, the mean voltage at the input of the integrator INT is given by:

$$V_{av}(F_{cb}) = V_{Itc} \leq (2/\pi) V_{osc} K_{a1} a_c \qquad (23)$$

where $a_c$ is the minimum attenuation of the sum of the moduli at $f_c$:

$$a_c = M_{A,B}(f_c) \qquad (24)$$

In the particular case of $G_A = G_B = G$ and $Q_A = Q_B = Q$, and $F_B >> F_A$, the relation (24) reduces to:

$$a_c = M_B(f_c) = G \left[ 1 + \left( \frac{F_B^2 - f_c^2}{F_B f_c} Q \right)^2 \right]^{-1/2} \qquad (25)$$

The discrimination voltages at the output of the detector RIV, obtained by integrating the relations (19) and (23) for a time $T_g >> 1/F_s$, are given by:

a) sensor SENS connected

$$V_{ts} = V_{Its} T_g/\tau = (2T_g/\pi\tau) V_{osc} K_{a1} 2a_s \qquad (26)$$

b) sensor SENS detached

$$V_{tc} = V_{ltc} \, T_g/\tau = (2T_g/\pi\tau) \, V_{osc} K_{a1} 2a_c \tag{27}$$

The discrimination factor therefore depends on the characteristic of the BPF filters according to the relation:

$$\frac{V_{ts}}{V_{tc}} \geq \frac{M_{A,B}(f_{as})}{M_{A,B}(f_c)} = 2\frac{a_s}{a_c} \tag{28}$$

From this relation it is noted that the discrimination factor is at least 6dB if the relations (18) and (22) are satisfied and the filters (or the filter) BPF are at least of the second order.
The margin between the two thresholds depends also on the integration time and is given by:

$$V_{th} = V_{ts} - V_{tc} = \frac{T_g V_{osc} K_{ai}}{\pi\tau} (2a_s - a_c) \tag{29}$$

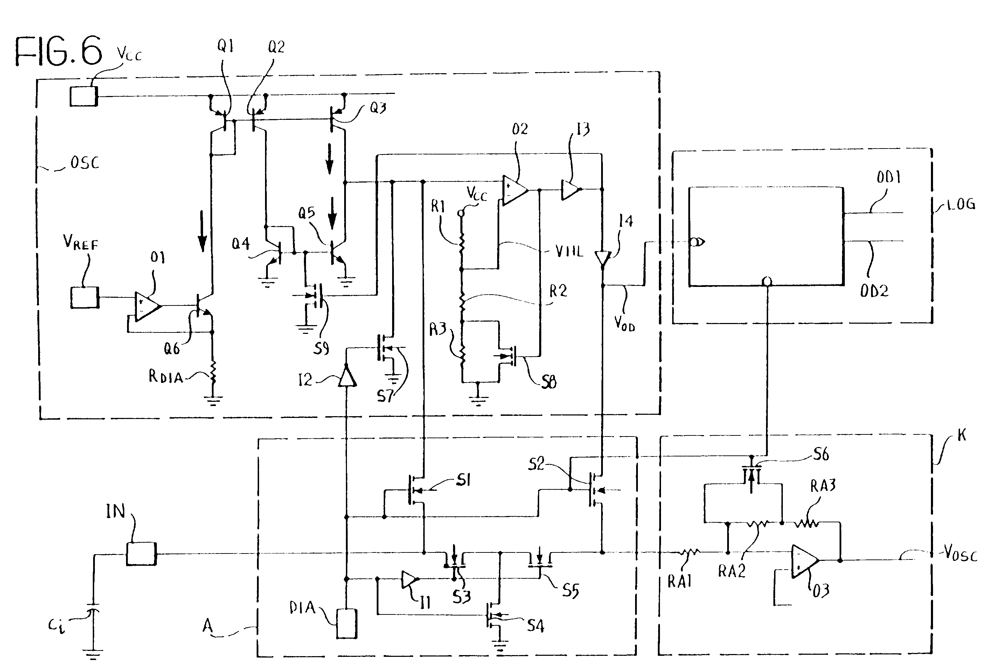

From relation (29) it is noted that, having established the oscillator frequency variations interval of the oscillator OSC the discrimination margin can be adjusted on the basis of the voltage of the oscillator OSC, the selectivity $a_s$ and the roll-off $a_c$ of the BPF filters.
An electric diagram of the conceptual type which implements the diagnostic system DIAGNOST is schematically shown, by way of example, in Figure 6.
The oscillator OSC is formed by transistors Q1-Q6, an amplifier O1, a comparator O2, resistors $R_{DIA}$, R1, R2 and R3, MOS type switches S7, S8 and S9 and invertors I2, I3 and I4.
The switching block is implemented by the invertors I1 and the MOS switches S1, S2, S3, S4 and S5 controlled by the signal DIA. Two invertors I3 and I4 at the output of a comparator O2 provide the square wave digital signal of the oscillator OSC.
The shifter K which provides the analogue signal of the oscillator OSC which supplies the detonation detector RIV is constituted by an operational amplifier O3, resistors RA1, RA2, RA3 and MOS switch S6. These components, as will be explained hereinbelow, form a variable gain amplifier the gain of which varies as a function of the signal DIA, and therefore, implement the oscillating signal adaptation constant K. This variable gain amplifier can replace the input interface INPUT of the detector RIV.
During normal operation, with the signal DIA at low logic level, the diagnostic system DIAGNOST is isolated from the detector RIV (except for the closure resistance of the switches S3 and S5 and the opening of the switches S1, S2 and S4), and the input load is connected directly to the interface amplifier INPUT.
During the diagnostic phase, with the signal DIA at high logic level, the diagnostic system DIAGNOST is interposed between the input load and the input INA of the detector RIV.
The individual blocks will now be analysed.
Oscillator and switches. The high level of the signal DIA enables diagnosis by closing the switches S1, S2 and S4 and opening the switches S3 and S5; the function of the switch S4 is to prevent cross-talk between the connection of the sensor SENS and the input INA of the detector RIV.
The oscillator OSC is activated by opening the reset switch S7 by means of the invertor I2. In these conditions the input capacity is connected to the non-inverting input of the comparator O2 the output of which is connected to the input of the amplifier O3 via the resistor RA1 and the invertors I3 and I4.
The oscillating function is obtained in a classical manner by charging and discharging an input capacitance $C_i$ with a constant current having value $I_s = V_{ref}/R_{DIA}$. This current $I_s$, generated by a voltage-current convertor formed by O1, Q6 and $R_{DIA}$, is mirrored by the transistor Q3, which generates the charging current, and by transistors Q2, Q4 and Q5 which generate a current $I_2 = 2I_s$.
The current generating transistor Q5 is cyclically enabled and disabled by the switch S9 controlled by the output of the comparator O2 via the invertor I3; the change high threshold of the comparator is obtained with the switch S8 open and is given by $V_H = V_{cc}(R2+R3)/(R1+R2+R3)$, whilst the change low threshold (switch S8 closed) is given by $V_L = V_{cc}R2/(R1+R2)$.
Across the terminals of the input capacitance $C_i$ is created a symmetrical triangular wave with peak-to-peak amplitude given by $V_{HL} = V_H - V_L$, whilst at the output of the inverter I4 there is a symmetrical square wave of amplitude given by $V_{HIGH} - V_{LOW} = V_{cc}$. The frequency of the oscillator OSC is therefore given by:

$$F_o = \frac{K_o}{C_i R_{DIA}} = \frac{2}{C_i R_{DIA}} \frac{V_{HL}}{V_{ref}} \qquad (30)$$

Adaptation Amplifier. The high level of the signal DIA closes the switch S6 short circuiting a part of the feedback resistance of the amplifier O3 . In these conditions the input signal of the BPF filters has an analogue amplitude defined by:

$$V_{osc} = KV_{od} = \frac{RA3}{RA1} V_{od} \qquad (31)$$

Diagnostic Logic. The high level of the signal DIA enables a logic circuit LOG. This circuit LOG counts n transitions of the oscillating signal taken from the output of the invertor I4 and produces at its output two logic signals OD1 and OD2 which partially diagnose the charge state of the input.

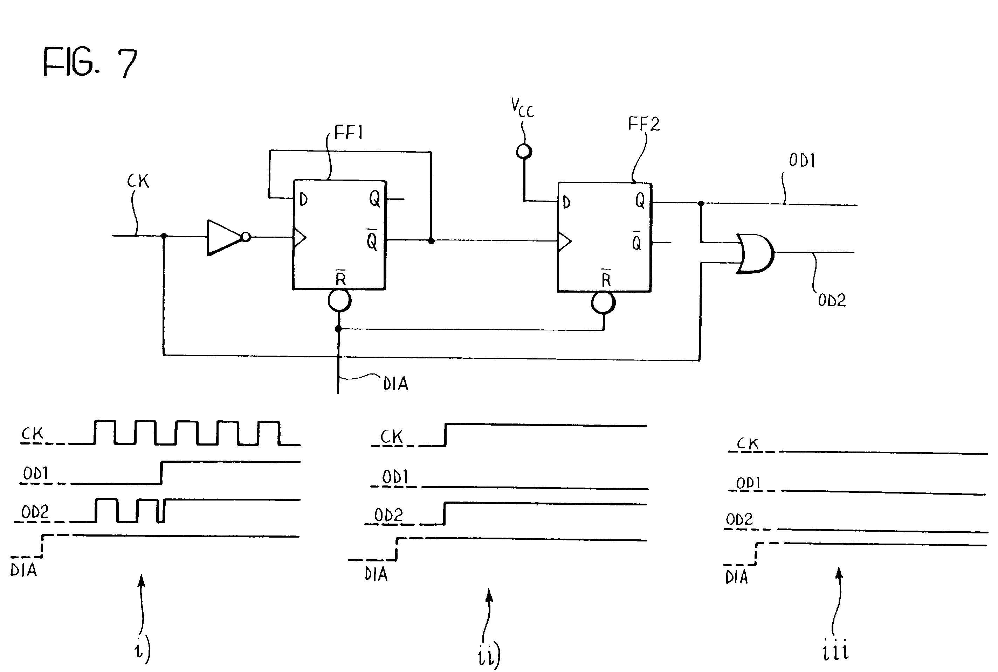

In Figure 7 there is shown a possible implementation of the logic circuit LOG in the particular case of counting two transitions of the oscillating signal by the use of two D-type flip-flops, FF1, FF2. In the same Figure 7 are shown further the plots of the logic signals CK, OD1, OD2 and DIA in the three conditions summarised in the following table:

| OD1 | OD2 | Condition |
|-----|-----|-----------|
| 1 | X | i) Input load purely capacitive with oscillator OSC operating. |
| 0 | 1 | ii) Oscillator OSC clamped at HIGH logic level: condition of short circuit to supply. |
| 0 | 0 | iii) Oscillator OSC clamped at LOW logic level: condition of short circuit to ground. |

The logic conditions of the table can be correlated with the output analogue voltage of the system to obtain the complete diagnosis of the state of the input load state.

The diagnostic implementation of Figures 6 and 7 can be utilised not only for diagnosing ideal short circuits (resistance nil) but also for diagnosing partial short circuits or alterations of the loss resistance $R_s$ of the sensor SENS. In fact, when the output of the oscillator OSC is clamped at the fixed level it is possible to distinguish the following conditions:

1) Output of the oscillator OSC is clamped at ground. Two cases can be distinguished:

a) there is a short circuit to ground, or
b) there is a resistance to ground present at the input such that the input signal does not reach the high threshold $V_H$ of the comparator O2, that is to say there is a resistance to ground at the input of a value $R_{iccm}$, given by

$$R_{iccm} \leq V_H/I_s = R_{DIA} \, V_H/V_{ref} \qquad (32)$$

The value $R_{iccm}$ can therefore be utilised to diagnose partial short circuit states or to diagnose an alteration of the internal resistance $R_s$ of the sensor SENS. In particular, the short circuit signal is valid even for $R_s < R_{iccm}$.

2) The output of the oscillator OSC is clamped at supply voltage $V_{cc}$. Two cases can be distinguished:

a) there is a short circuit to the supply $V_{cc}$, or
b) a resistance between the input and the supply $V_{cc}$ (or a DC source) is present so that the signal, having reached the high threshold $V_H$, does not fall below the low threshold $V_L$ of the comparator O2; that is to say, there is a resistance between the input and the supply $V_{cc}$ of the value $R_{icca}$ given by:

$$R_{icca} \leq \frac{V_{cc} - V_L}{I_s} = R_{DIA} \frac{V_{cc} - V_L}{V_{ref}} \qquad (33)$$

The value $R_{icca}$ thus discriminates between the partial short circuit resistance to the supply $V_{cc}$.

The system described here has been developed in particular for diagnosing the state of the load at the input of a detonation detection circuit, applicable in engine control computers which utilise accelerometric sensors of capacitive type as detonation transducer sensors. However, the system is of a general type and can be applied to systems with one or more detection channels as long as they operate a frequency-voltage conversion with band pass filtering.

Naturally, the principle of the invention remaining the same, the details of construction and the embodiments can be widely varied with respect to what has been described and illustrated, without by this departing from the ambit of the present invention as defined in the annexed Claims.

## Claims

1. A diagnostic system (DIAGNOST) for a capacitive sensor (SENS) which is associated with a detector circuit (RIV) operable to generate an output signal (OUT) indicative of a physical quantity detected by the said sensor (SENS), the said detector circuit (RIV) comprising a band pass filter (BPF) configured in such a way as to filter a signal generated by the said sensor (SENS); the diagnostic system (DIAGNOST) being capable of being interposed between the said sensor (SENS) and the said detector circuit (RIV) and comprising oscillator means (OSC) having a variable oscillation frequency dependent on a capacitance present at an input (IN) of the system (DIAGNOST) intended to be connected to the said sensor (SENS), said oscillator means (OSC) being configured in such a way that for at least one failure condition of the said sensor (SENS) said oscillator means (OSC) causes generation of a frequency such that the said detector circuit (RIV), by means of the said filter (BPF), allows discrimination of the said at least one failure condition on the said output signal (OUT); the system (DIAGNOST) being characterised in that the said oscillator means (OSC) is configured in such a way as to provide an output frequency which:

   - is within the band of the said band pass filter (BPF) when the said sensor (SENS) is correctly functioning;
   - is outside the band of the said band pass filter (BPF) when the said sensor (SENS) has a failure condition,

   in order to discriminate the said failure condition by means of the said output signal (OUT) of the said detector circuit (RIV).

2. A system according to Claim 1, characterised in that said oscillator means (OSC) is dimensioned in such a way that its output frequency is greater than the band of the said band pass filter (BPF) when the said sensor (SENS) is disconnected.

3. A system according to Claim 1 or 2, characterised in that the said oscillator means (OSC) is dimensioned in such a way that its output frequency is less than the band of the said band pass filter (BPF) when the said sensor (SENS) is short circuited.

4. A system according to Claim 3, characterised in that the said short circuit is to ground.

5. A system according to Claim 3, characterised in that the said short circuit is to a DC voltage source ($V_{cc}$).

6. A system according to any of Claims from 1 to 5, characterised in that the said oscillator means (OSC) is a digital oscillator capable of generating a square wave signal.

7. A system according to Claim 6, characterised in that the said oscillator means (OSC) is adapted to remain clamped at one logic value in the case of a short circuit of the said sensor (SENS).

8. A system according to any of Claims from 1 to 7, characterised in that it includes a switching circuit (A) capable of assuming:

   - a first operative condition in which the said sensor (SENS) is connected directly to the said detector circuit (RIV),
   - a second operative condition in which the said diagnostic system (DIAGNOST) is interposed between the said sensor (SENS) and the said detector circuit (RIV).

9. A system according to Claim 8, characterised in that the said switching circuit (A) is capable of selectively assuming one of the said first and second operative conditions according to a logic signal (DIA) for activating the diagnosis.

10. A system according to Claim 8 or Claim 9, characterised in that the said switching circuit (A) comprises three MOS switches.

**11.** A system according to any of Claim from 1 to 10, characterised in that it includes an adaptation circuit (K) connected to the output of the said oscillator means (OSC) for multiplying the periodic signal emitted by the said oscillator means (OSC) by a scale factor (k) in order to adapt said signal to the said detection circuit (RIV).

**Patentansprüche**

**1.** Diagnosesystem (DIAGNOST) für einen kapazitiven Sensor (SENS) mit einer zugeordneten Auswerteschaltung (RIV), die zur Erzeugung eines für eine vom Sensor (SENS) detektierte physikalische Größe stehenden Ausgangssignals (OUT) betätigbar ist, wobei die Auswerteschaltung (RIV) einen für das Filtern eines vom Sensor (SENS) erzeugten Signals gestalteten Bandpaßfilter (BPF) umfaßt; das Diagnosesystem (DIAGNOST) zwischen dem Sensor (SENS) und der Auswerteschaltung (RIV) geschaltet sein kann und eine Oszillatoreinrichtung (OSC) mit einer variablen Oszillationsfrequenz aufweist, welche von einer am Eingang (IN) des an den Sensor (SENS) anzuschließenden Systems (DIAGNOST) vorhandenen Kapazitanz abhängt, und die Oszillatoreinrichtung (OSC) derart gestaltet ist, daß für zumindest eine Fehlerbedingung des Sensors (SENS) die Oszillatoreinrichtung (OSC) die Erzeugung einer Frequenz bewirkt, so daß die Auswerteschaltung (RIV) mittels des Filters (BPF) die Unterscheidung der zumindest einen Fehlerbedingung am Ausgangssignal (OUT) zuläßt, welches System (DIAGNOST) dadurch gekennzeichnet ist, daß die Oszillatoreinrichtung (OSC) derart gestaltet ist, daß eine Ausgangsfrequenz geschaffen wird, welche:

> innerhalb des Wellenlängenbereichs des Bandpaßfilters (BPF) liegt, wenn der Sensor (SENS) richtig funktioniert;
> außerhalb des Wellenlängenbereichs des Bandpaßfilters (BPF) liegt, wenn der Sensor (SENS) eine Fehlerbedingung hat,

um die Fehlerbedingung mittels des Ausgangssignals (OUT) der Auswerteschaltung (RIV) zu unterscheiden.

**2.** System nach Anspruch 1, dadurch gekennzeichnet, daß die Oszillatoreinrichtung (OSC) derart dimensioniert ist, daß ihre Ausgangsfrequenz größer als der Wellenlängenbereich des Bandpaßfilters (BPF) ist, wenn der Sensor (SENS) nicht angeschlossen ist.

**3.** System nach Anspruch 1 oder 2, dadurch gekennzeichnet, daß die Oszillatoreinrichtung (OSC) derart dimensioniert ist, daß ihre Ausgangsfrequenz kleiner als der Wellenlängenbereich des Bandpaßfilters (BPF) ist, wenn der Sensor (SENS) kurzgeschlossen ist.

**4.** System nach Anspruch 3, dadurch gekennzeichnet, daß der Kurzschluß zur Masse besteht.

**5.** System nach Anspruch 3, dadurch gekennzeichnet, daß der Kurzschluß zu einer Gleichstromspannungsquelle (Vcc) besteht.

**6.** System nach einem der Ansprüche 1 bis 5, dadurch gekennzeichnet, daß die Oszillatoreinrichtung (OSC) ein digitaler Oszillator ist, welcher ein Rechtecksignal erzeugen kann.

**7.** System nach Anspruch 6, dadurch gekennzeichnet, daß die Oszillatoreinrichtung (OSC) so ausgelegt ist, daß sie im Fall eines Kurzschlusses des Sensors (SENS) an einem logischen Wert angeklemmt bleibt.

**8.** System nach einem der Ansprüche 1 bis 7, dadurch gekennzeichnet, daß es einen Schaltkreis (A) inkludiert, welcher einnehmen kann:

> eine erste Betriebsbedingung, in welcher der Sensor (SENS) direkt an die Auswerteschaltung (RIV) angeschlossen ist,
> eine zweite Betriebsbedingung, in welcher das Diagnosesystem (DIAGNOST) zwischen dem Sensor (SENS) und der Auswerteschaltung (RIV) geschaltet ist.

**9.** System nach Anspruch 8, dadurch gekennzeichnet, daß der Schaltkreis (A) gezielt die erste oder die zweite Betriebsbedingung gemäß einem logischen Signal (DIA) zur Aktivierung der Diagnose annehmen kann.

**10.** System nach Anspruch 8 oder Anspruch 9, dadurch gekennzeichnet, daß der Schaltkreis (A) drei MOS-Schalter umfaßt.

**11.** System nach einem der Ansprüche 1 bis 10, dadurch gekennzeichnet, daß es eine Anpassungsschaltung (K) inkludiert, welche zur Vervielfachung des von der Oszillatoreinrichtung (OSC) entsendeten periodischen Signals um einen Skalenfaktor (k) zwecks Anpassung des Signals an die Auswerteschaltung (RIV) an den Ausgang der Oszillatoreinrichtung (OSC) angeschlossen ist.

**Revendications**

1. Système de diagnostique (DIAGNOST) pour un capteur capacitif (SENS) qui est associé à un circuit de détection (RIV) pouvant fonctionner pour générer un signal de sortie (OUT) indiquant une quantité physique détectée par ledit capteur (SENS), ledit circuit de détection (RIV) comprenant un filtre passe-bande (BPF) configuré de manière à filtrer un signal généré par ledit capteur (SENS) ; le système de diagnostique (DIAGNOST) étant capable d'être intercalé entre ledit capteur (SENS) et ledit circuit de détection (RIV) et comprenant un moyen oscillateur (OSC) ayant une fréquence d'oscillation variable en fonction d'une capacité présente à l'entrée (IN) du système (DIAGNOST) prévue pour être connectée audit capteur (SENS), ledit moyen oscillateur (OSC) étant configuré de telle manière que pour au moins un état d'erreur dudit capteur (SENS), ledit moyen oscillateur (OSC) entraîne une génération d'une fréquence telle que ledit circuit de détection (RIV), au moyen dudit filtre (BPF), permette la discrimination dudit au moins un état d'erreur sur ledit signal de sortie (OUT) ; le système (DIAGNOST) étant caractérisé en ce que ledit moyen oscillateur (OSC) est configuré de manière à délivrer une fréquence de sortie qui:

   - se trouve dans la bande dudit filtre passe-bande (BPF) lorsque ledit capteur (SENS) fonctionne correctement;
   - se trouve en-dehors de la bande dudit filtre passe-bande (BPF) lorsque ledit capteur (SENS) est dans un état d'erreur,

     afin de discriminer ledit état d'erreur au moyen dudit signal de sortie (OUT) dudit circuit de détection (RIV).

2. Système selon la revendication 1, caractérisé en ce que ledit moyen oscillateur (OSC) est dimensionné de telle manière que sa fréquence de sortie soit plus importante que la bande dudit filtre passe-bande (BPF) lorsque ledit capteur (SENS) est déconnecté.

3. Système selon la revendication 1 ou 2, caractérisé en ce que ledit moyen oscillateur (OSC) est dimensionné de telle manière que sa fréquence de sortie soit inférieure à la bande dudit filtre passe-bande (BPF) lorsque ledit capteur (SENS) est court-circuité.

4. Système selon la revendication 3, caractérisé en ce que ledit court-circuit est à la masse.

5. Système selon la revendication 3, caractérisé en ce que ledit court-circuit est à une source de tension continue (VCC).

6. Système selon l'une quelconque des revendications 1 à 5, caractérisé en ce que ledit moyen oscillateur (OSC) est un oscillateur numérique capable de générer un signal d'onde carrée.

7. Système selon la revendication 6, caractérisé en ce que ledit moyen oscillateur (OSC) est adapté pour rester fixé à une valeur logique dans le cas d'un court-circuit dudit capteur (SENS).

8. Système selon l'une quelconque des revendications 1 à 7, caractérisé en ce qu'il comprend un circuit de commutation (A) capable d'occuper:

   - un premier état de fonctionnement dans lequel ledit capteur (SENS) est connecté directement audit circuit de détection (RIV),
   - un second état de fonctionnement dans lequel ledit système diagnostique (DIAGNOST) est intercalé entre ledit capteur (SENS) et ledit circuit de détection (RIV).

9. Système selon la revendication 8, caractérisé en ce que ledit circuit de commutation (A) est capable d'occuper de manière sélective l'un des premier et second états de fonctionnement selon un signal logique (DIA) pour activer le diagnostic.

**10.** Système selon la revendication 8 ou la revendication 9, caractérisé en ce que ledit circuit de commutation (A) comprend trois commutateurs à transistors MOS.

**11.** Système selon l'une quelconque des revendications 1 à 10, caractérisé en ce qu'il comprend un circuit d'adaptation (K) connecté à la sortie dudit moyen oscillateur (OSC) pour multiplier le signal périodique émis par ledit moyen oscillateur (OSC) par un facteur d'échelle (k) afin d'adapter ledit signal audit circuit de détection (RIV).

FIG. 1

EP 0 704 706 B1

# FIG. 2

EP 0 704 706 B1

FIG. 3

# FIG. 4

IN

Vod

Vosc

Vra

VzB

OUT

GATE

Tg

DIA

EP 0 704 706 B1

FIG. 5

$2a_S = M_{A,B}(f_{as})$

$M_A(f)$

$M_B(f)$

$M_{A,B}(f)$

$a_C = M_{A,B}(f_C)$

$f_{a1}$

$F_A$

$F_B$

$f_C$

$f_{as}$

$f_{b1}$

$f$

FIG.6

EP 0 704 706 B1

19

# FIG. 7

EP 0 704 706 B1